# EUROPÄISCHE PATENTSCHRIFT

(11) **EP 2 073 618 B1**
(45) Veröffentlichungstag und Bekanntmachung des Hinweises auf die Patenterteilung: **26.01.2011**
(21) Anmeldenummer: 07024408.2
(22) Anmeldetag: 17.12.2007
(51) Int. Cl.: H05K 7/20

(54) **Elektronisches Gerät**
Electronic device
Appareil électronique

(43) Veröffentlichungstag der Anmeldung: 24.06.2009
(73) Patentinhaber: SIEMENS AKTIENGESELLSCHAFT, 80333 München (DE)
(72) Erfinder: Becker, Peter, 76571 Gaggenau (DE)

(56) Entgegenhaltungen:
- EP-A- 0 236 711
- DE-U1- 20 320 926
- GB-A- 1 604 368
- US-A1- 2007 230 183

## Beschreibung

Die Erfindung betrifft ein elektronisches Gerät mit einer elektronischen Komponente und einem Kühlkörper zur Abführung der Wärme der elektronischen Komponente während des Betriebs des elektronischen Gerätes.

Ein derartiges Gerät ist aus dem Siemens-Katalog "ST 70 - 2007" SIMATIC S7, Seite 4/2 bekannt. Innerhalb einer Gehäusekapsel einer Baugruppe ist eine mit elektrischen und elektronischen Bauteilen versehene Leiterplatte angeordnet. Die Entwärmung dieser Bauteile erfolgt im Wesentlichen durch Konvektion in der Art und Weise, dass Luft durch eine Öffnung auf der Unterseite der Gehäusekapsel über die Bauteile und schließlich durch eine Öffnung auf der Oberseite der Gehäusekapsel strömt, wobei die durch das Gehäuse strömende Luft den Bauteilen Wärme entzieht.

In der europäischen Patentanmeldung 06018133.6 wird ein aus mehreren Baugruppen bestehendes Automatisierungsgerät vorgeschlagen. Jede Baugruppe weist eine Gehäusekapsel mit einer Rückwand und zwei Seitenwänden auf, von denen eine thermisch leitfähig und die andere Seitenwand thermisch isolierend ausgebildet ist. Die Baugruppen sind so angeordnet, dass jeweils eine thermisch leitfähige Seitenwand einer Baugruppe zu einer thermisch isolierten Seitenwand einer anderen Baugruppe benachbart ist. Die Entwärmung der Baugruppen erfolgt im Wesentlichen durch thermische Konvektion. Dazu strömt Luft durch einen von einer thermisch isolierten Seitenwand einer Baugruppe und einer thermisch leitfähigen Seitenwand einer benachbarten Baugruppe gebildeten Kamin von einem Kamineintritt zu einem Kaminaustritt, wobei die Luft der thermisch leitfähigen Seitenwand der benachbarten Baugruppe Wärme entzieht. Maßnahmen zur Vermeidung von Verwirbelungen im Kanal, welche sich störend auf die Wärmeabfuhr auswirken, sind nicht vorgesehen.

GB 1 604 368 beschreibt ein Trägersystem für Leiterplatten, welches mit einem Kanal aus Metall versehen ist.

DE 203 20 926 U1 offenbart ein Kühlelement für elektrische Bauteile, das mit einem rohrförmigen Element und einem wärmeleitenden Verbindungsteil zur Verbindung des rohrförmigen Elements mit einem zu kühlenden Bauteil versehen ist. Es wird vorgeschlagen, das wärmeleitende Verbindungsteil und das rohrförmige Element aus einem Stück zu fertigen und die innere Oberfläche zur besseren Wärmeabgabe schwarz zu gestalten.

Aus der US 2007/230183 A1 ist ein elektronisches Gerät mit den im Oberbegriff des Anspruchs 1 angegebenen Maßnahmen bekannt.

Der vorliegenden Erfindung liegt die Aufgabe zugrunde, ein elektronisches Gerät der eingangs genannten Art mit einer verbesserten Konvektion zu schaffen.

Diese Aufgabe wird durch die im kennzeichnenden Teil des Anspruchs 1 angegebenen Maßnahmen gelöst.

Vorteilhaft ist, dass eine im Wesentlichen laminare Luftströmung in den Luftkanälen erzielt wird. Verwirbelungen bzw. Turbulenzen in den Luftkanälen werden vermieden und es wird ein sehr hoher Luftdurchsatz in den Luftkanälen ermöglicht. Die mindestens vier Symmetrieachsen aufweisenden Querschnitte der Luftkanäle sind beispielsweise quadratisch oder kreisförmig ausgebildet.

In einer Ausgestaltung der Erfindung ist vorgesehen, die Luftkanäle im Wesentlichen jeweils konisch oder im Wesentlichen in Form eines Hyperboloids auszubilden. Durch eine derartige Reduzierung des Längsquerschnitts der Luftkanäle wird die Strömungsgeschwindigkeit in den Luftkanälen erhöht, wodurch die Wärme schneller abgeführt werden kann. Für den Fall, dass der Längsquerschnitt in Form eines Hyperboloids ausgebildet ist, was bedeutet, dass am Ende des Luftkanals - wie aus der Geometrie eines Kühlturms in der Kraftwerkstechnik bekannt ist - der Querschnitt des Luftkanals ausgeweitet ist, wird der Wirkungsgrad im Hinblick auf die Luftströmung bzw. Wärmeabfuhr verbessert.

In einer weiteren Ausgestaltung der Erfindung ist vorgesehen, dass Innenwände der Luftkanäle mit einer Schmutz abweisenden Beschichtung versehen sind oder dass die Luftkanäle aus Schmutz abweisendem Material bestehen. Durch die Verschmutzung einer Innenwand eines Luftkanals können in diesem Verwirbelungen entstehen, welche den laminaren Luftstrom beeinträchtigen. Aufgrund der durch die Beschichtung erzielten geringen Benetzbarkeit der Innenwand (Lotuseffekt) ist weitgehend sichergestellt, dass der laminare Luftstrom nicht störend beeinflusst wird.

Gemäß einer weiteren Ausgestaltung der Erfindung wird die Luft über einen Luftführungskörper dem Kühlkörper zugeführt. Eine derartige Maßnahme ist insbesondere in Schaltschränken mit mehreren in Zeilen angeordneten Baugruppen vorteilhaft. Dort erfolgt die Luftzufuhr von einer Frontseite des Schaltschrankes und die Warmluft wird hinter den Baugruppenzeilen zwischen diesen und der Rückseite des Schaltschrankes abgeleitet. Durch die Konzentration der warmen Luft auf der Rückseite des Schaltschrankes entstehen eine stärkere Konvektion der Luft hinter den Baugruppenzeilen und damit eine bessere und gleichmäßigere Kühlung der einzelnen Baugruppenzeilen. Dabei können Baugruppen mit einem erhöhten Kühlbedarf mit einem sich verengenden Ansaugkanal versehen werden.

Weitere vorteilhafte Ausgestaltungen der Erfindung ergeben sich aus den weiteren Unteransprüchen.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1 bis 7: Anordnungen mit Mitteln zur Wärmeabfuhr und
- Figur 8: ein modulares Automatisierungsgerät.

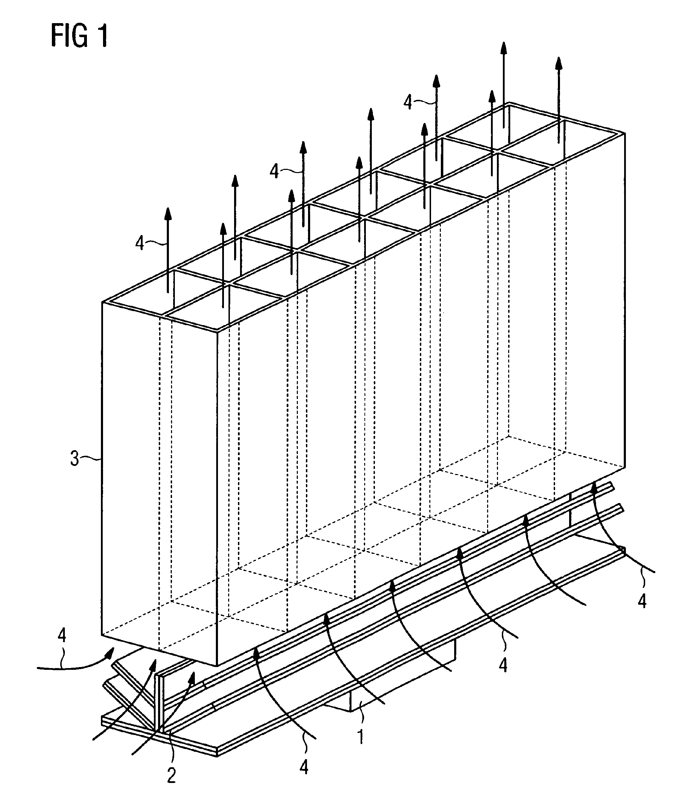

Die in den Figuren 1 bis 8 dargestellten gleichen Teile sind mit gleichen Bezugszeichen versehen.

In Figur 1 ist mit 1 eine auf einem Kühlkörper 2 angeordnete elektronische Komponente, z. B. eine elektronische Komponente in Form eines Prozessors, bezeichnet. Der Prozessor kann beispielsweise Bestandteil einer Leiterplatte einer CPU-, einer Kommunikations-, einer I/O- oder einer sonstigen Funktions-Baugruppe eines Automatisierungsgerätes bzw. einer speicherprogrammierbaren Steuerung sein. Oberhalb des Kühlkörpers 2 sind Luftkanäle 3 mit quadratischem Querschnitt angeordnet, welche aus nicht wärmespeicherndem Material bestehen, was bedeutet, dass diese nicht als Wärmetauscher geeignet sind. Diese Luftkanäle 3 bewirken eine im Wesentlichen laminare Luftströmung; Verwirbelungen bzw. Turbulenzen in den Luftkanälen 3 werden vermieden, wodurch die Luftströmung in den Luftkanälen nicht behindert wird. Aufgrund des dadurch bewirkten hohen Luftdurchsatzes in diesen Luftkanälen 3 wird eine sehr gute Wärmeabfuhr erzielt. Die während des Betriebs erzeugte Wärme bzw. thermische Verlustleistung der elektronischen Komponente 1 bzw. eines elektronischen Gerätes, welche diese elektronische Komponente 1 umfasst, wird dem Kühlkörper 2 zugeführt und schließlich aufgrund der Luftströmung 4 über die Luftkanäle 3 abgeführt.

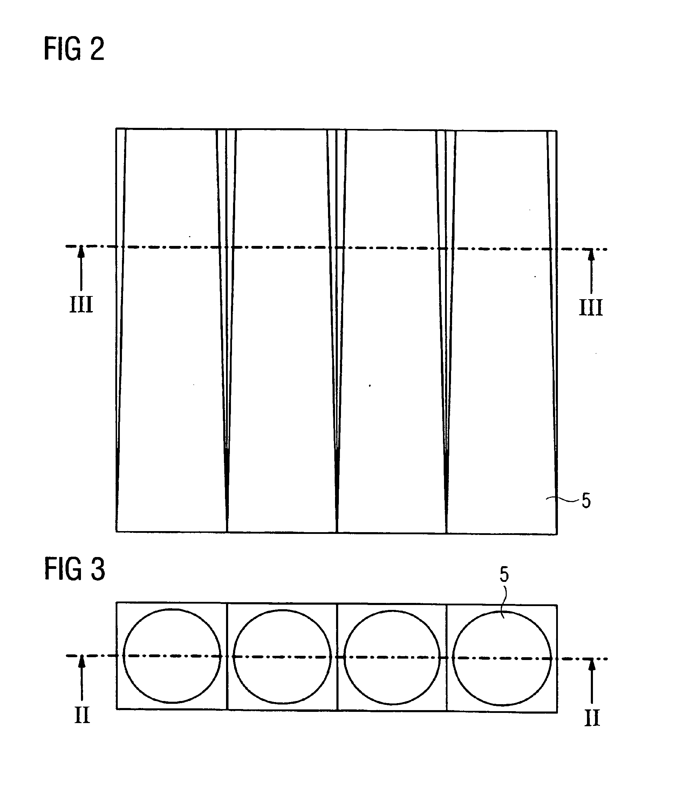

In den Figuren 2 und 3 ist in Schnittdarstellungen eine Ausführungsform von Luftkanälen 5 gezeigt, die einen kreisförmigen Querschnitt aufweisen und ferner konisch ausgebildet sind. Auch bei einer derartigen Ausführungsform mit kreisförmigem Querschnitt wird eine im Wesentlichen laminare Luftströmung erzielt und darüber hinaus aufgrund der Reduzierung des Querschnitts in Luftströmungsrichtung die Strömungsgeschwindigkeit in den Luftkanälen 5 erhöht und somit die Wärmeabfuhr verbessert.

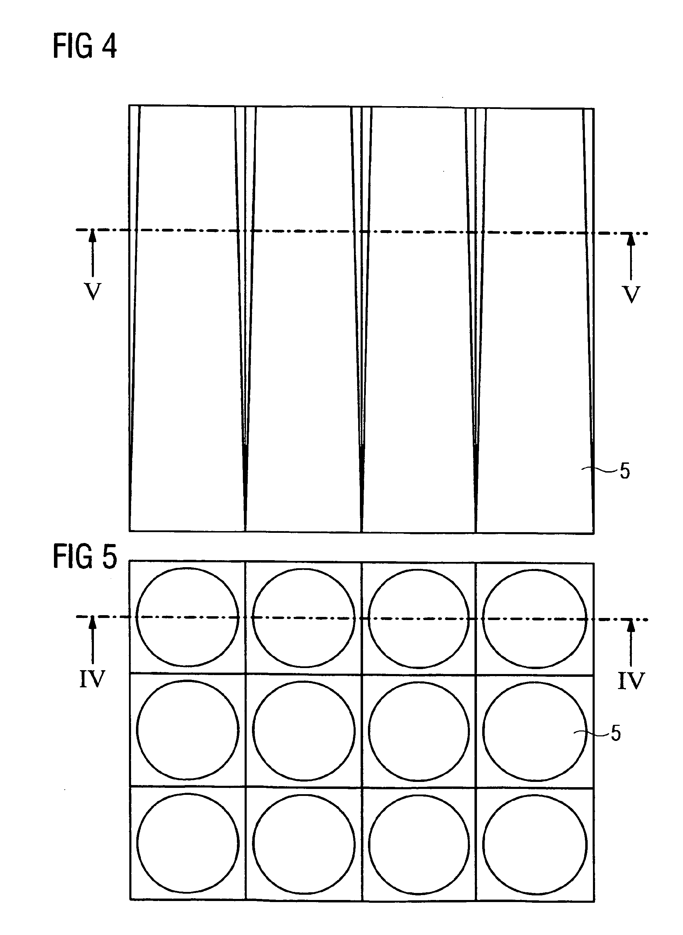

Im Unterschied zur Ausführungsform gemäß den Figuren 2 und 3 zeigen Figur 4 und 5 in Schnittdarstellungen eine Ausführungsform von matrixförmig angeordneten Luftkanälen 5. Dadurch wird weitgehend sichergestellt, dass der Gesamtluftstrom ausreichend ist, um die Wärme abzuführen, wobei das Verhältnis von Länge und Querschnitt der Luftkanäle 5 optimal gewählt wird, um eine sehr gute "Kaminwirkung" zu erzielen.

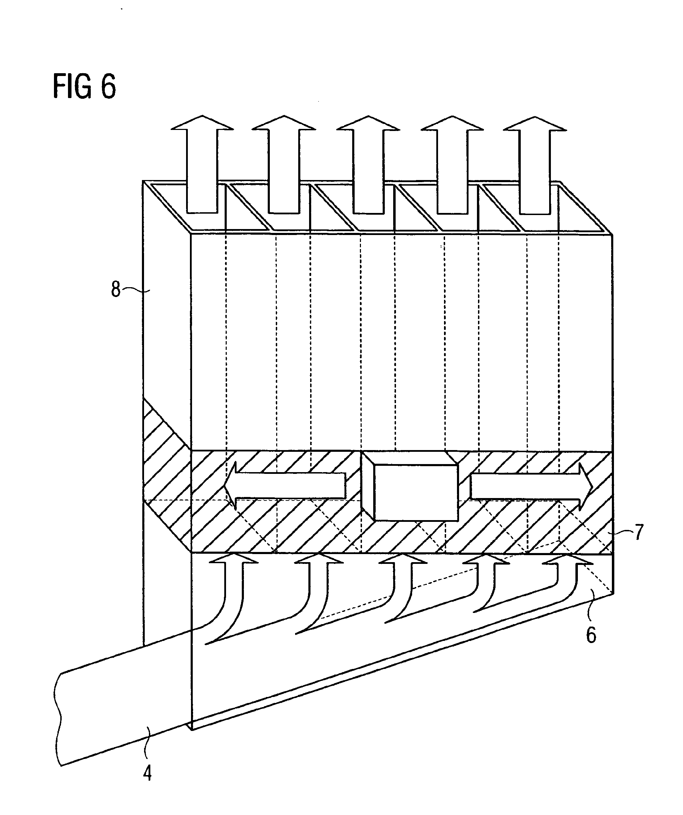

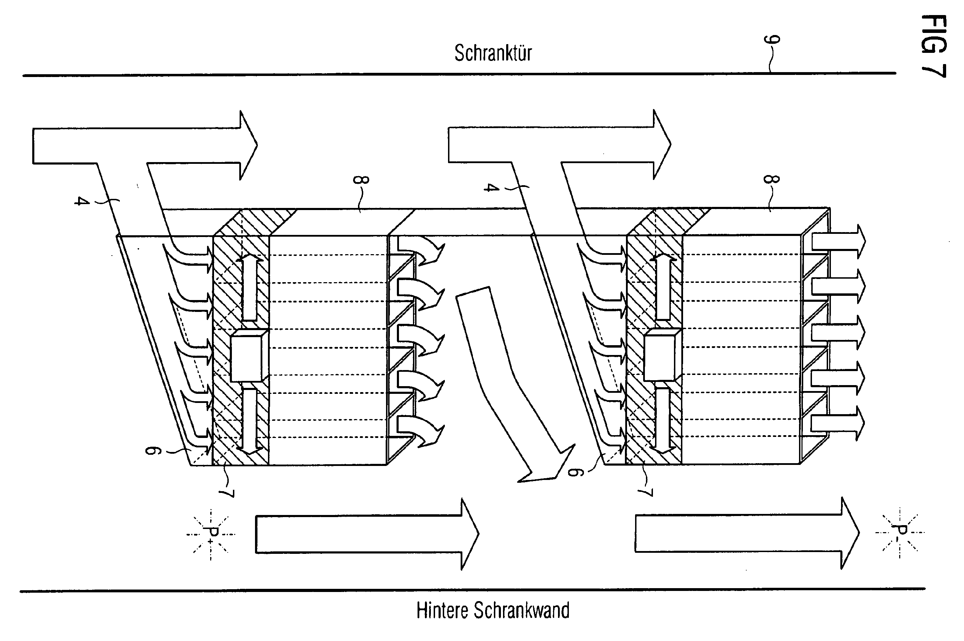

In Figur 6 ist eine Anordnung zur Wärmeabfuhr mit einem Luftführungskörper 6 dargestellt, welcher unterhalb eines Kühlkörpers 7 angeordnet ist, wobei die Luft über den Luftführungskörper 6 zum Kühlkörper 7 geführt und die Wärme über Luftkanäle 8 abgeführt wird. Zur besseren Übersicht sind wärmeerzeugende elektronische Komponenten nicht dargestellt. Ein Einsatz von derartigen Luftführungskörpern ist insbesondere in einem Schaltschrank (Figur 7) mit mehreren in Zeilen angeordneten Baugruppen vorteilhaft. Dort erfolgt die Luftzufuhr von einer Frontseite 9 des Schaltschrankes und die Warmluft wird hinter den Baugruppenzeilen im Bereich einer Rückseite 10 des Schaltschrankes abgeleitet. Durch die Konzentration der warmen Luft auf der Rückseite 10 des Schaltschrankes entstehen eine stärkere Konvektion der Luft hinter den Baugruppenzeilen und damit eine bessere und gleichmäßigere Kühlung der einzelnen Baugruppenzeilen.

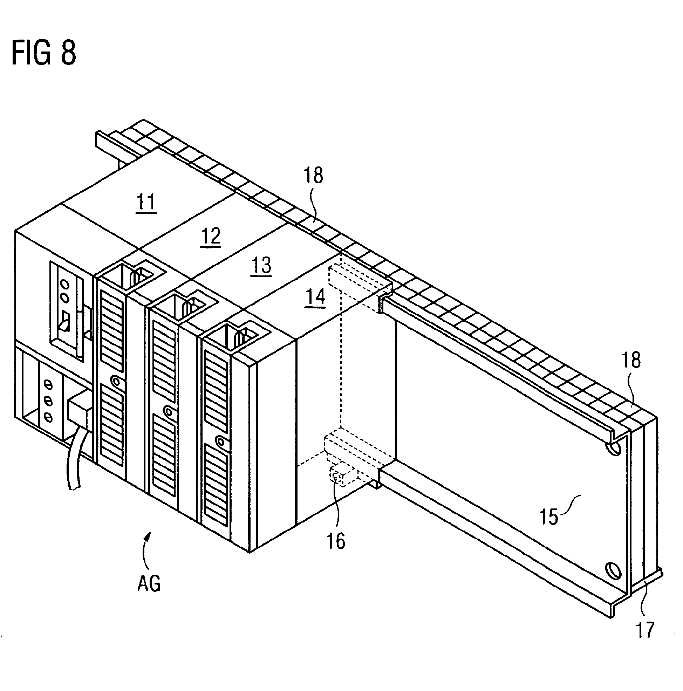

In Figur 8 ist ein elektronisches Gerät in Form eines modularen, aus mehreren Baugruppen bestehenden Automatisierungsgerätes AG dargestellt. Im Unterschied zu den Ausführungsformen gemäß den Figuren 1 bis 7 ist ein Kühlkörper außerhalb der Baugruppen angeordnet. Eine Zentral- bzw. CPU-Baugruppe 11 sowie mehrere Peripheriebaugruppen 12, 13, 14, z. B. Peripheriebaugruppen in Form von Ein-/Ausgabebaugruppen, sind über einen hier nicht dargestellten Bus miteinander verbunden und nebeneinander auf einen Träger in Form einer Hutschiene 15 aufgeschwenkt. Weitere Teile der Baugruppen, z. B. Teile wie Leiterplatten mit entsprechender Bestückung und/oder weitere elektronisch und/oder mechanische Komponenten, sind zum besseren Verständnis der Erfindung nicht erforderlich und werden daher nicht näher erläutert. Die Baugruppen 11 bis 14 sind jeweils nach dem Aufschwenken mittels einer Schraubverbindung 16 auf der Hutschiene 15 gesichert, wobei diese Schraubverbindung 16 und/oder weitere hier nicht dargestellte wärmeleitfähige Kontaktierungsmittel vorgesehen sind, um die jeweils in den Baugruppen 11 bis 14 entstehende Wärme einem um 90° abgewinkelten Teil 17 auf der Rückseite des Trägers 15 zuzuführen. Dieser abgewinkelte Teil 17, welcher sich über die gesamte Länge des Trägers 15 erstreckt, ist als Kühlkörper vorgesehen, auf welchem quadratische Luftkanäle 18 aus nicht wärmespeicherndem Material angeordnet sind. Dadurch wird eine im Wesentlichen laminare Luftströmung in den Luftkanälen erzielt; Verwirbelungen bzw. Turbulenzen in den Luftkanälen werden vermieden und es wird ein sehr hoher Luftdurchsatz in den Luftkanälen und sehr gute Wärmeabfuhr bewirkt.

## Patentansprüche

1. Elektronisches Gerät mit einer elektronischen Komponente (1) und einem Kühlkörper (2) zur Abführung der Wärme der elektronischen Komponente (1) während des Betriebs des elektronischen Gerätes (AG), wobei über dem Kühlkörper (2; 7; 17) Luftkanäle (3; 5; 8; 18) angeordnet sind, **dadurch gekennzeichnet, dass** die Luftkanäle (3; 5; 8; 18) aus nicht wärmespeicherndem Material bestehen und jeweils einen Querschnitt mit mindestens vier Symmetrieachsen aufweisen.>

2. Elektronisches Gerät nach Anspruch 1, **dadurch gekennzeichnet, dass** die Luftkanäle (3; 5; 8; 18) im Wesentlichen jeweils konisch oder in Form eines Hyperboloids ausgebildet sind.

3. Elektronisches Gerät nach Anspruch 1 oder 2, **dadurch gekennzeichnet, dass** die Luftkanäle (3; 5; 8; 18) matrix- oder wabenförmig angeordnet sind.

4. Elektronisches Gerät nach einem der Ansprüche 1 bis 3, **dadurch gekennzeichnet, dass** die Innenwände der Luftkanäle (3; 5; 8; 18) mit einer Schmutz abweisenden Beschichtung versehen sind oder dass die Luftkanäle (3; 5; 8; 18) aus Schmutz abweisendem Material bestehen.

5. Elektronisches Gerät nach einem der Ansprüche 1 bis 4, **dadurch gekennzeichnet, dass** ein Luftführungskörper (6) vorgesehen ist, über welchen dem Kühlkörper (2; 7; 17) Luft zugeführt wird.

6. Elektronisches Gerät nach einem der Ansprüche 1 bis 5, **dadurch gekennzeichnet, dass** das elektronische Gerät eine Baugruppe (11, 12, 13, 14) eines mehrere Baugruppen (11, 12, 13, 14) aufweisenden Automatisierungsgerätes (AG) ist.

7. Elektronisches Gerät nach Anspruch 6, **dadurch gekennzeichnet, dass** der Kühlkörper (2; 7; 17) und die Luftkanäle (3; 5; 8; 18) an einer Seitenwand der Baugruppe (11, 12, 13, 14) angeordnet sind.

8. Elektronisches Gerät nach einem der Ansprüche 1 bis 5, **dadurch gekennzeichnet, dass** das elektronische Gerät ein mehrere Baugruppen (11, 12, 13, 14) aufweisendes Automatisierungsgerät (AG) ist, das einen metallischen Träger (15) aufweist, auf welchen die Baugruppen (11, 12, 13, 14) aufschwenkbar sind, wobei aufgeschwenkte Baugruppen (11, 12, 13, 14) thermisch mit dem Träger (15) verbunden sind und wobei der Kühlkörper (17) und die Luftkanäle (18) auf der Rückseite des Trägers (15) angeordnet sind.

9. Elektronisches Gerät nach Anspruch 8, **dadurch gekennzeichnet, dass** der Kühlkörper durch einen im Wesentlichen um 90° abgewinkelten Teil (17) des Trägers (15) gebildet ist.

10. Elektronisches Gerät nach einem der Ansprüche 1 bis 5, **dadurch gekennzeichnet, dass** das elektronische Gerät ein Personalcomputer ist.

## Claims

1. Electronic device having an electronic component (1) and a cooling element (2) for dissipating the heat from the electronic component (1) during operation of the electronic device (AG), with air ducts (3; 5; 8; 18) being arranged above the cooling element (2; 7; 17), **characterized in that** the air ducts (3; 5; 8; 18) consist of non heat-storing material and each comprise a cross-section having at least four axes of symmetry.

2. Electronic device according to claim 1, **characterized in that** the air ducts (3; 5; 8; 18) are each essentially embodied conically or in the form of a hyperboloid.

3. Electronic device according to claim 1 or 2, **characterized in that** the air ducts (3; 5; 8; 18) are arranged in the manner of a matrix or honeycomb.

4. Electronic device according to one of claims 1 to 3, **characterized in that** the inner walls of the air ducts (3; 5; 8; 18) are provided with a dirt-repelling coating or that the air ducts (3; 5; 8; 18) are made of dirt-repelling material.

5. Electronic device according to one of claims 1 to 4, **characterized in that** an air guiding element (6) is provided, by way of which air is fed to the cooling element (2; 7; 17).

6. Electronic device according to one of claims 1 to 5, **characterized in that** the electronic device is a component (11, 12, 13, 14) of an automation device (AG) comprising several components (11, 12, 13, 14).

7. Electronic device according to claim 6, **characterized in that** the cooling element (2; 7; 17) and the air ducts (3; 5; 8; 18) are arranged on a side wall of the component (11, 12, 13, 14).

8. Electronic device according to one of claims 1 to 5, **characterized in that** the electronic device is an automation device (AG) comprising several components (11, 12, 13, 14), said automation device (AG) having a metallic carrier (15), onto which the components (11, 12, 13, 14) can be pivoted, with pivoted components (11, 12, 13, 14) being thermally connected to the carrier (15) and with the cooling element (17) and the air ducts (18) being arranged on the rear of the carrier (15).

9. Electronic device according to claim 8, **characterized in that** the cooling element is formed by a part (17) of the carrier (15) which is essentially angled by 90°.

10. Electronic device according to one of claims 1 to 5, **characterized in that** the electronic device is a personal computer.

## Revendications

1. Appareil électronique comprenant un composant ( 1 ) électronique et un dissipateur ( 2 ) de chaleur pour l'évacuation de la chaleur du composant ( 1 ) électronique pendant le fonctionnement de l'appareil ( AG ) électronique, dans lequel des canaux ( 3 ;5 ;8 ;18 ) pour de l'air sont disposés sur le dissipateur ( 2 ;7 ;17 ) de chaleur, **caractérisé en ce que** les canaux ( 3 ;5 ;8 ;18 ) pour de l'air sont en un matériau qui n'accumule pas de la chaleur et ont respectivement une section transversale ayant au moins quatre axes de symétrie.

2. Appareil électronique suivant la revendication 1, **caractérisé en ce que** les canaux ( 3 ;5 ;8 ;18 ) pour de l'air sont sensiblement coniques ou ont la forme d'un hyperboloïde.

3. Appareil électronique suivant la revendication 1 ou 2, **caractérisé en ce que** les canaux ( 3 ;5 ;8 ;18 ) pour le l'air sont disposés en forme de matrice ou en nid d'abeille.

4. Appareil électronique suivant l'une des revendications 1 à 3, **caractérisé en ce que** les parois intérieures des canaux ( 3 ;5 ;8 ;18 ) pour de l'air sont munies d'un revêtement repoussant la saleté ou **en ce que** les canaux ( 3 ;5 ;8 ;18 ) pour de l'air sont en un matériau repoussant la saleté.

5. Appareil électronique suivant l'une des revendications 1 à 4, **caractérisé en ce qu'**il est prévu un corps ( 6 ) de guidage, par lequel de l'air est envoyé au dissipateur ( 2 ;7 ;17 ) de chaleur.

6. Appareil électronique suivant l'une des revendications 1 à 5, **caractérisé en ce que** l'appareil électronique est un module ( 11, 12, 13, 14 ) d'un appareil ( AG ) d'automatisation comportant plusieurs modules ( 11, 12, 13, 14 ).

7. Appareil électronique suivant la revendication 6, **caractérisé en ce que** le dissipateur ( 2 ;7 ;17 ) de chaleur et les canaux ( 3 ;5 ;8 ;18 ) pour de l'air sont disposés sur une paroi latérale du module ( 11, 12, 13, 14 ).

8. Appareil électronique suivant l'une des revendications 1 à 5, **caractérisé en ce que** l'appareil électronique est un appareil ( AG ) d'automatisation comportant plusieurs modules ( 11, 12, 13, 14 ) ayant un support ( 15 ) métallique, sur lequel les modules ( 11, 12, 13, 14 ) peuvent être basculés, des modules ( 11, 12, 13, 14 ) basculés étant reliés thermiquement au support ( 15 ) et le dissipateur ( 17 ) de chaleur et les canaux ( 18 ) pour de l'air étant disposés sur la face arrière du support ( 15 ).

9. Appareil électronique suivant la revendication 8, **caractérisé en ce que** le dissipateur de chaleur est formé par une partie du support ( 15 ) coudée sensiblement à 90°.

10. Appareil électronique suivant l'une des revendications 1 à 5, **caractérisé en ce que** l'appareil électronique est un ordinateur personnel.
